# EUROPEAN PATENT APPLICATION

(11) **EP 4 836 069 A1**
(43) Date of publication of application: **04.11.2026**
(21) Application number: 24910340.9
(22) Date of filing: 08.11.2024
(51) Int. Cl.: H01M 10/42, H01M 50/569, H01M 50/583

(54) **BATTERY PACK AND VEHICLE**

(30) Priority: 29.12.2023 CN 202311871893
(71) Applicant: Zhejiang Geely Holding Group Co., Ltd., Hangzhou, Zhejiang 310051 (CN); Geely Automobile Research Institute (Ningbo) Co., Ltd., Ningbo, Zhejiang 315336 (CN)
(72) Inventor: LIU, Houshi, Hangzhou, Zhejiang 310051 (CN); PENG, Junlong, Hangzhou, Zhejiang 310051 (CN); SHI, Changdong, Hangzhou, Zhejiang 310051 (CN); YANG, Linfeng, Hangzhou, Zhejiang 310051 (CN)
(74) Representative: Range, Christopher William
(86) International application number: PCT/CN2024/130949
(87) International publication number: WO 2025/139403

(57) **Abstract**

Provided are a battery pack and a vehicle. The battery pack includes a casing and an electronic control structure. The casing has a side access opening formed at the casing. The electronic control structure is disposed in the casing and directly faces the side access opening. The electronic control structure includes a first BDU unit including a first electrical housing, a fuse, and a current sensor. The first electrical housing has a first opening facing the side access opening. The fuse and the current sensor are detachably disposed in the first electrical housing. The current sensor is connected in series with the fuse.

## Description

### CROSS-REFERENCE TO RELATED APPLICATION

This application claims priority to Chinese Patent Application No. 202311871893.2, filed on December 29, 2023 and entitled "BATTERY PACK AND VEHICLE", the entire disclosure of which are incorporated herein by reference.

### FIELD

The present disclosure relates to the field of battery technologies, and in particular, to a battery pack and a vehicle.

### BACKGROUND

With the iterative update of new energy technologies, the technology of cell-to-chassis integration continues to evolve. That is, by directly integrating a battery pack into a chassis of a vehicle, a higher degree of integration is achieved. The battery pack includes a casing, an upper cover, a battery group, and an electrical connection component. The battery pack further includes an upper cover. An installation cavity is defined between the casing and the upper cover, and the battery group and the electrical connection component are arranged within the installation cavity. The battery pack and the electrical connection component are located between the casing and the upper cover. The upper cover of the battery pack is located at a bottom of a vehicle body and serves as a vehicle chassis to bear a weight of the entire battery pack.

In the related art, design types for disassembly, assembly, and maintenance of an electronic control structure of the battery pack are limited. In order to improve the degree of integration and optimize the design, it is necessary to develop more types of electronic control structures.

### SUMMARY

The present disclosure aims to solve at least one of the technical problems existing in the related art. To this end, an objective of the present disclosure is to provide a battery pack, in which an electrical module is arranged in a split manner to improve convenience of inspection and maintenance.

The present disclosure further provides a vehicle.

The battery pack according to an embodiment of the present disclosure includes a casing and an electronic control structure. The casing has a side access opening formed at the casing. The electronic control structure is disposed in the casing and directly faces the side access opening. The electronic control structure includes a first BDU unit including a first electrical housing, a fuse, and a current sensor. The first electrical housing has a first opening facing the side access opening. The fuse and the current sensor are detachably disposed in the first electrical housing. The current sensor is connected in series with the fuse.

For the battery pack according to the embodiment of the present disclosure, the electronic control structure is configured in the aforesaid manner, which enables accurate positioning of both the fuse and the current sensor while contributing to structural compactness. The provision of the first BDU unit is helpful to achieve functions of high-voltage on-off and safety protection. As the fuse and the current sensor have a relatively higher failure rate compared with other electrical components, their detachable arrangement facilitates maintenance operations.

In some embodiments, the first electrical housing has a first positioning cavity and a second positioning cavity that are open towards the side access opening, the fuse being located in the first positioning cavity, and the current sensor being located in the second positioning cavity; first positioning protuberances are formed on at least one side of the first positioning cavity inside the first electrical housing, an end of the fuse being detachably connected to the first positioning protuberances; and second positioning protuberances are formed on at least one side of the second positioning cavity inside the first electrical housing. An end of the current sensor is detachably connected to the second positioning protuberances.

In an embodiment of the present disclosure, a threaded hole is formed at each of a surface of the first positioning protuberances facing the side access opening and a surface of the second positioning protuberances facing the side access opening. The fuse is connected to the first positioning protuberances by bolts, and the current sensor is connected to the second positioning protuberances by bolts.

Further, the first positioning protuberances and the second positioning protuberances are staggered in height and are at different distances from the side access opening.

In an embodiment of the present disclosure, the first electrical housing is internally provided with at least one first positioning protuberance. A rear surface of each of the at least one first positioning protuberance has a second threaded hole, and the first positioning cavity is defined between the at least one first positioning protuberance, the fuse being located in the first positioning cavity, two ends of the fuse being connected to the at least one first positioning protuberance through second bolts, each of the second bolts being threadedly engaged with the corresponding second threaded hole; and the first electrical housing is provided with at least one second positioning protuberance. A rear surface of each of the at least one second positioning protuberance has a third threaded hole. The second positioning cavity is defined between the at least one second positioning protuberance. The current sensor is located in the second positioning cavity. Two ends of the current sensor are connected to the at least one second positioning protuberance through third bolts. Each of the third bolts is threadedly engaged with the corresponding third threaded hole.

Further, the at least one first positioning protuberance are arranged in a left-right direction, and the at least one second positioning protuberance are arranged in the left-right direction, and the at least one second positioning protuberance and the at least one first positioning protuberance are different in height, the rear surface of the first positioning protuberance and the rear surface of the second positioning protuberance are staggered in a front-rear direction; and each of a projection of the second bolt on a rear side wall and a projection of the third bolt on the rear side wall is located within the coverage of the side access opening.

In an embodiment of the present disclosure, the first BDU unit further includes a first conductive sheet located in the first positioning cavity at a side of the fuse away from the side access opening. A part of a side edge of the first conductive sheet extends laterally and is bent to be connected to one of the first positioning protuberances to be electrically connected to the fuse; and a part of an upper edge of the first conductive sheet extends upward and is bent to be connected to one of the second positioning protuberances to be electrically connected to the current sensor.

One of the second positioning protuberances is located directly above corresponding one of the first positioning protuberances, and a dimension of the current sensor in the left-right direction is smaller than that of the fuse in the left-right direction.

In an embodiment of the present disclosure, the first electrical housing has a second opening at a top of the first electrical housing. The first BDU unit further includes a top protection cover and two second conductive sheets. The two second conductive sheets are spaced apart from each other in a left-right direction and disposed at the top of the first electrical housing, and each of the two second conductive sheets extends in a front-rear direction.

The battery pack further includes a battery group. A rear end of one of the two second conductive sheets is bent downward to rest on one of the first positioning protuberances to be electrically connected to the fuse, and a rear end of the other one of the two second conductive sheets is bent downward to rest on one of the second positioning protuberances to be electrically connected to the current sensor. A front end of each of the two second conductive sheets is connected to the battery group through a copper busbar. The top protection cover is detachably connected to the top of the first electrical housing and covers over the two second conductive sheets.

In an embodiment of the present disclosure, the current sensor has a first plug interface at a rear side of the current sensor, and the top protection cover has a first through-hole directly facing the first plug interface.

In an embodiment of the present disclosure, a top surface of the top protection cover has a limiting slot extending in the front-rear direction, a front end of the limiting slot directly facing the first through-hole; and the top protection cover is further provided with a limiting protrusion on at least one side of the limiting slot.

In some embodiments, the electronic control structure further includes a BMS main control board and a BMS slave control board that are respectively located at two sides of the first BDU unit and directly faces the side access opening.

A vehicle according to an embodiment of the present disclosure includes a vehicle body and the battery pack as described in the above embodiments. The vehicle body has a passenger space formed in the vehicle body. The battery pack is mounted at a bottom of the vehicle body.

For the vehicle according to the embodiment of the present disclosure, the adoption of the above battery pack can improve an integration level of the vehicle. After a structure of the battery pack is optimized, it is convenient to inspect and repair faults of the battery pack.

In an embodiment of the present disclosure, the vehicle body has a mounting opening formed at the bottom of the vehicle body, and the battery pack is disposed in the mounting opening; and the vehicle body further has an upwardly recessed cavity at the bottom of the vehicle body. A rear end of the battery pack directly faces the upwardly recessed cavity.

Additional aspects and advantages of the present disclosure will be provided in part in the following description, or will become apparent in part from the following description, or can be learned from practicing of the present disclosure.

### BRIEF DESCRIPTION OF THE DRAWINGS

The above and/or additional aspects and advantages of the present disclosure will become more apparent and more understandable from the description of embodiments taken in conjunction with the accompanying drawings, in which:
FIG. 1 is a schematic overall view of a battery pack according to an embodiment of the present disclosure;
FIG. 2 is a schematic view of a positional relationship between an electrical module and a battery group from a viewing angle according to an embodiment of the present disclosure;
FIG. 3 is an exploded view of a battery pack from a viewing angle according to an embodiment of the present disclosure;
FIG. 4 is a schematic view of a positional relationship between an electrical module and a battery group from another viewing angle according to an embodiment of the present disclosure;
FIG. 5 is a structural view of a battery pack with components and parts hidden from a viewing angle according to an embodiment of the present disclosure;
FIG. 6 is a structural view of a battery pack with components and parts hidden from another viewing angle according to an embodiment of the present disclosure;
FIG. 7 is a schematic structural view of a wiring harness of an electrical module according to an embodiment of the present disclosure;
FIG. 8 is a schematic top view of an electrical module according to an embodiment of the present disclosure;
FIG. 9 is a schematic front view of a partial structure of an electrical module according to an embodiment of the present disclosure;
FIG. 10 is a schematic structural view of a battery pack with a side access cover open according to an embodiment of the present disclosure;
FIG. 11 is a schematic view of a partial structure of a battery pack with a wiring harness hidden and a side access cover open according to an embodiment of the present disclosure;
FIG. 12 is a schematic top view of partial structures of a casing and a support frame according to an embodiment of the present disclosure;
FIG. 13 is a schematic top view of partial structures of a casing, a support frame, and a mounting plate according to an embodiment of the present disclosure;
FIG. 14 is a schematic view of partial structures of a casing, a support frame, and a mounting plate from another viewing angle according to an embodiment of the present disclosure;
FIG. 15 is a schematic rear view of structures of a casing and a support frame according to an embodiment of the present disclosure;
FIG. 16 is a schematic view of an assembly structure of a BMS main control board from a viewing angle according to an embodiment of the present disclosure;
FIG. 17 is a schematic view of an assembly structure of a BMS main control board from another viewing angle according to an embodiment of the present disclosure;
FIG. 18 is a schematic view of an assembly structure of a BMS slave control board from a viewing angle according to an embodiment of the present disclosure;
FIG. 19 is a schematic view of an assembly structure of a BMS slave control board from another viewing angle according to an embodiment of the present disclosure;
FIG. 20 is a schematic structural view of a first BDU unit from a viewing angle according to an embodiment of the present disclosure;
FIG. 21 is an exploded schematic view of a first BDU unit from another viewing angle according to an embodiment of the present disclosure;
FIG. 22 is an exploded schematic view of a battery pack from yet another viewing angle according to an embodiment of the present disclosure;
FIG. 23 is a partially enlarged view of FIG. 22;
FIG. 24 is a schematic structural view of a second electrical portion according to an embodiment of the present disclosure;
FIG. 25 is an exploded view of a second electrical portion according to an embodiment of the present disclosure;
FIG. 26 is a schematic structural view of a shock-absorbing post according to an embodiment of the present disclosure;
FIG. 27 is a schematic view of a partial structure of a second electrical housing according to an embodiment of the present disclosure;
FIG. 28 is a schematic structural view of a bottom protection plate and a buffer layer on the bottom protection plate according to some embodiments of the present disclosure;
FIG. 29 is a schematic view of a partial structure of a bottom protection plate according to other embodiments of the present disclosure;
FIG. 30 is a schematic view of a frame side beam and a mounting beam according to other embodiments of the present disclosure.
FIG. 31 is an overall view of a vehicle according to an embodiment of the present disclosure;
FIG. 32 is a positional relationship view of a battery pack in a vehicle body according to an embodiment of the present disclosure.

Reference numerals:
vehicle 1000;
battery pack 100;
casing 1, frame 10, front side wall 11, rear side wall 12, left side wall 13, right side wall 14, bottom protection plate 15, thickened layer 151, top plate 16, mounting beam 17, buffer layer 18,
side access opening 101, first fixing hole 111; exhaust port 102, frame side beam 103, frame body portion 1031,
battery group 2, battery sub-group 20, battery cell 201, pressure relief member 202;
electrical module 3,
electrical connection structure 31,
first wiring harness 311, first flexible wire 3111, first plug connector 3112, second flexible wire 3113, second plug connector 3114, third flexible wire 3115, third plug connector 3116,
second wiring harness 312, second signal transmission interface 3121,
third wiring harness 313, fourth wiring harness 314,
high-voltage electrical terminal 315, low-voltage electrical terminal 316, copper busbar 317,
electronic control structure 32,
first BDU unit 321, first electrical housing 3211, first opening 3211a, second opening 3211b, first positioning protuberance 3211c, second threaded hole 3211d, first positioning cavity 3211e, second positioning protuberance 3211f, third threaded hole 3211g, second positioning cavity 3211h, fuse 3212, current sensor 3213, first plug interface 32131, first conductive sheet 3214, second conductive sheet 3215, top protection cover 3216, first through-hole 3216a, limiting slot 3216b, limiting protrusion 3216c, first snap-fit portion 3216d, side protection cover 3217, second snap-fit portion 3217a, arc-shaped plate 3217b,
BMS main control board 322, second plug interface 3221,
BMS slave control board 323, third plug interface 3231,
mounting plate 324, flange 3241, mounting hole 3242,
first bolt 3291, second bolt 3292, third bolt 3293, fourth bolt 3294, fifth bolt 3295,
second electrical portion 33, fourth flexible wire 331, second electrical housing 332, shock-absorbing post 333, thick post segment 3331, thin post segment 3332, central hole 3333, first extension plate 3351, second extension plate 3352, engagement hook 33521, lower protrusion 336, second through-hole 3361, wire clamp 3362, main relay 337, electrical connection strip 338, first signal transmission interface 339;
support frame 4, support longitudinal rod 40, first longitudinal rod 401, second longitudinal rod 402, third longitudinal rod 403, fourth longitudinal rod 404, support cross rod 41, first threaded hole 411, avoidance groove 412;
partition assembly 5, cross beam 51, lower cross bar 511, upper cross bar 512, first notch 5131, second notch 5132, third notch 5133, longitudinal beam 52, seat mounting nut 53, front cavity 54, rear cavity 55, receiving sub-cavity 56, flow passage 561, width of flow passage x1,
liquid cooling plate 6, liquid cooling pipe 601, liquid cooling connector 602, bottom access opening 61, fastening bolt 611, sealing ring 62, bottom access cover 63, side access cover 64, air pressure balance valve 65, seat fixing fastener 66, fixing plate 67;
vehicle body 200, passenger space 220, mounting opening 230, upwardly recessed cavity 240.

### DETAILED DESCRIPTION

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limiting, the present disclosure.

In description of the present disclosure, it should be understood that orientations or positional relationships indicated by terms "longitudinal", "transverse", "length", "width", "thickness", "upper", "lower", "front", "rear", "left", "right", "top", "bottom", "inner", "outer", and the like are based on orientations or positional relationships shown in the drawings, and facilitate the description of the present disclosure and simplify the description merely, rather than indicating or implying that the associated apparatus or element must have specific orientations and are constructed and operated in the specific orientations, and thus should not be construed to limit the present disclosure. In addition, features associated with "first" and "second" may include at least one or more such features, either explicitly or implicitly. In the description of the present disclosure, unless otherwise indicated, "plurality of" means two or more.

In the description of the present disclosure, it should be noted that, unless expressly stated or limited otherwise, the terms "mounted", "connected", "coupled" shall be understood in a broad sense. For example, it may be a fixed connection, a detachable connection or an integral connection; it may be a mechanical connection or an electrical connection; it may be a direct connection or an indirect connection through an intermediate medium; it may also be internal communication between two elements. For those skilled in the art, the specific meaning of the above-mentioned terms in the embodiments of the present disclosure can be understood according to specific circumstances.

A battery pack 100 according to the embodiments of the present disclosure is described below with reference to the accompanying drawings. The battery pack 100 according to the embodiments of the present disclosure includes an electronic control structure 32. The electronic control structure 32 extends in a first direction D1 or a second direction D2 of the battery pack 100. In order to facilitate understanding of the electronic control structure 32, the following description is provided in conjunction with the structure of the battery pack 100 according to some embodiments.

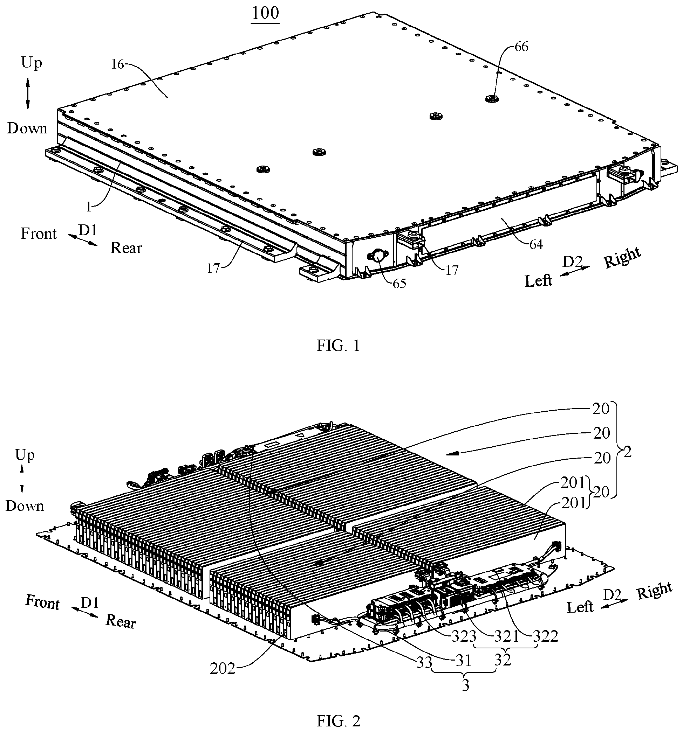

As shown in FIG. 1 to FIG. 6, the battery pack 100 according to an embodiment of the present disclosure includes a casing 1, a battery group 2, and an electrical module 3.

The casing 1 has a front side wall 11 and a rear side wall 12, and a side access opening 101 is formed on the rear side wall 12. The battery group 2 is located in the casing 1.

The electrical module 3 is mounted in the casing 1. The electrical module 3 includes an electrical connection structure 31 and an electronic control structure 32. In some solutions, the electrical module 3 is of a split structure, i.e., the electrical module 3 includes an electrical connection structure 31, an electronic control structure 32, and a second electrical portion 33, with the electronic control structure 32 serving as a first electrical portion. The electronic control structure 32 is located at a rear side of the battery group 2 and directly faces the side access opening 101. The second electrical portion 33 is located at a front side of the battery group 2. The electrical connection structure 31 is configured to be electrically connected to the electronic control structure 32, the second electrical portion 33, and the battery group 2. The electrical module 3 further includes a high-voltage electrical terminal 315 and a low-voltage electrical terminal 316 that are disposed on the electrical connection structure 31. The high-voltage electrical terminal 315 and the low-voltage electrical terminal 316 are mounted on the casing 1.

It should be noted here that in the present disclosure, the descriptions of "high voltage" and "low voltage" do not limit to specific voltages, but limit to relative voltage levels. A voltage of high-voltage electricity is usually a supply voltage of the battery pack 100 as a power source, while a voltage of low-voltage electricity is usually a signal transmission voltage in the battery pack 100.

It can be understood that the application field of the battery pack 100 is not limited. Depending on different installation positions of the battery pack 100, adaptive adjustments can be made to the battery pack 100 in the first direction D1 and the second direction D2. Each of the first direction D1 and the second direction D2 is perpendicular to a height direction. A height direction of the battery pack 100 is an up-down direction shown in FIG. 1. When the battery pack 100 is mounted on the vehicle 1000, the first direction D1 is a front-rear direction, and the second direction D2 is a left-right direction.

In the related art, the electrical modules of the battery pack include a BDU (i.e., Battery Disconnect Unit) and a BMS (i.e., Battery Management System). The BDU realizes functions of high-voltage on-off and safety protection through control of the BMS. In practical applications, the electrical modules are concentrated at a side of the battery pack, and long busbars are provided to realize an electrical connection inside the battery pack. Moreover, the number of long busbars is at least three.

In the present disclosure, the electrical module 3 is divided into the electronic control structure 32 and the second electrical portion 33, which can reduce circuit connections running through the front and rear of the battery pack 100. Therefore, application costs of the electrical connections and a weight of the battery pack 100 can be reduced, and electrical layout in the battery pack 100 can be optimized.

With the battery pack 100 according to the embodiment of the present disclosure, by configuring the electrical module 3 as the electronic control structure 32 and the second electrical portion 33, the electrical layout in the battery pack 100 can be facilitated, and a spatial arrangement of the electrical module 3 inside the battery pack 100 can be optimized. In the related art, a space occupied by the electrical module in the battery pack is smaller than a space occupied by the battery group, and height dimensions of part of electrical modules are greater than a height dimension of the battery group. In order to receive the electrical module in the casing, it is necessary to increase a size of the casing, which also increases a size of the entire battery pack and reduces a utilization rate of an internal space of the battery pack. In the present disclosure, the optimized design can facilitate a reduction in the height of the electrical module 3, for example, making the height dimension of the battery group 2 greater than or equal to the height dimension of the electrical module 3, thus avoiding an increase in a size of the battery pack 100 caused by an excessively high height of the electrical module 3 and improving the utilization rate of the internal space of the battery pack 100.

A height dimension of each component in the present disclosure refers to a dimension of the component in the height direction (i.e., the up-down direction in FIG. 1).

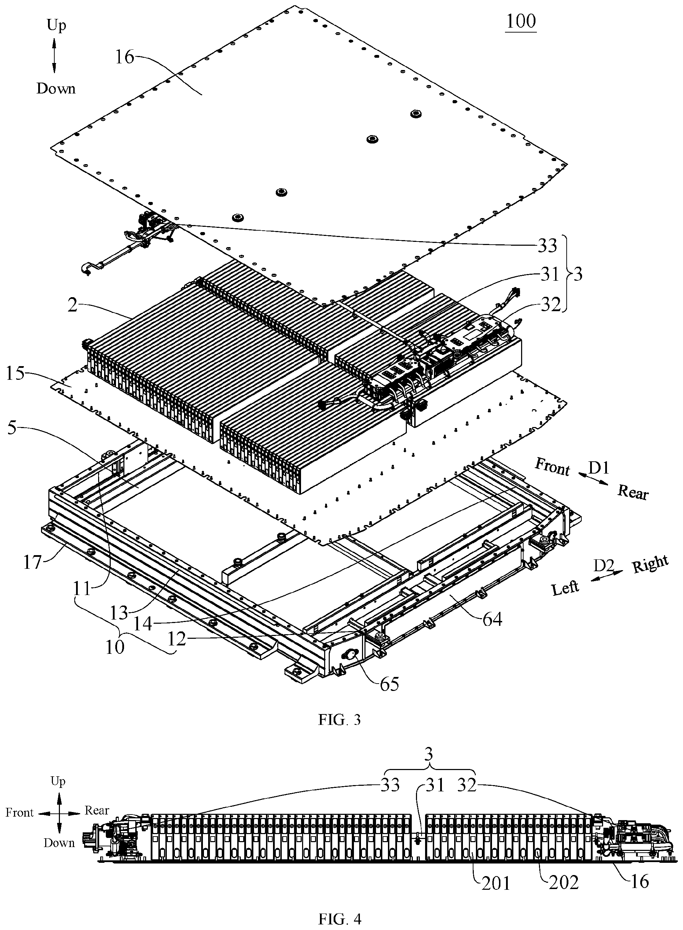

In some embodiments, as shown in FIG. 1 and FIG. 3, the casing 1 includes a frame 10, a top plate 16 connected to a top of the frame 10, and a bottom protection plate 15 connected to a bottom of the frame 10.

In an embodiment of the present disclosure, a shape of the frame 10 usually determines an overall shape of the battery pack 100. The frame 10 may be a square frame, a hexagonal frame, or the like. A common frame 10 is in a quadrilateral shape. In an embodiment of the present disclosure, the frame 10 is formed by connecting side beams on four sides end to end, and each side beam constitutes a side wall of the casing 1, namely the front side wall 11, the rear side wall 12, the left side wall 13, and the right side wall 14, respectively. Each side beam may be made of section steel or processed from roll-formed steel. Further, there is a mounting beam 17 connected to the frame 10. The mounting beam 17 may be mounted on the side beam. For example, the mounting beam 17 is mounted to each of the front side wall 11, the rear side wall 12, the left side wall 13, and the right side wall 14. Further, when the battery pack 100 is assembled, the side beam of the frame 10 is connected to the top plate 16 and the bottom protection plate 15 by bolts to improve connection reliability.

In an embodiment of the present disclosure, during assembly, a top of the battery group 2 is directly adhesively connected to the top plate 16, allowing the top of the battery group 2 and the top plate 16 to be integrated inseparably. In another embodiment of the present disclosure, during assembly, a bottom of the battery group 2 is directly adhesively connected to the bottom protection plate 15, allowing the bottom of the battery group 2 and the bottom protection plate 15 to be integrated inseparably. Certainly, the solution of the present disclosure is not limited thereto. The bottom protection plate 15 may also be configured as a detachable connection structure to facilitate disassembly and maintenance of the battery pack 100 from the bottom. The top plate 16 may also be configured as a detachable connection structure to facilitate disassembly and maintenance of the battery pack 100 from the top.

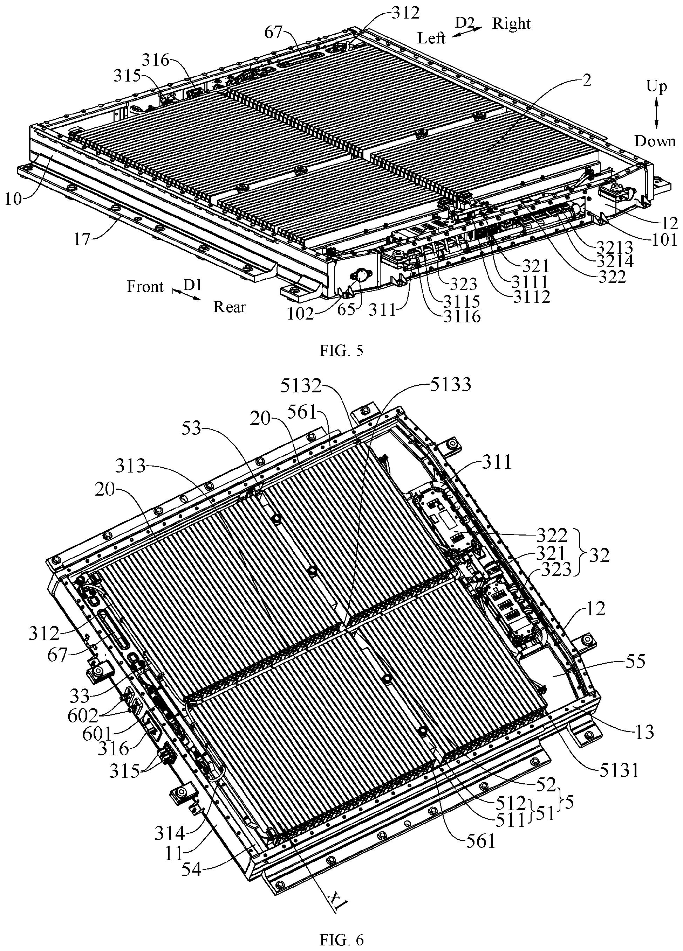

In some embodiments, as shown in FIG. 6 to FIG. 8, the electronic control structure 32 includes a first BDU unit 321, a BMS main control board 322, and a BMS slave control board 323. The first BDU unit 321 is located between the BMS main control board 322 and the BMS slave control board 323. The second electrical portion 33 includes a second BDU unit. The BMS main control board 322 and the BMS slave control board 323 are located at both sides of the first BDU unit 321 and both directly faces the side access opening 101.

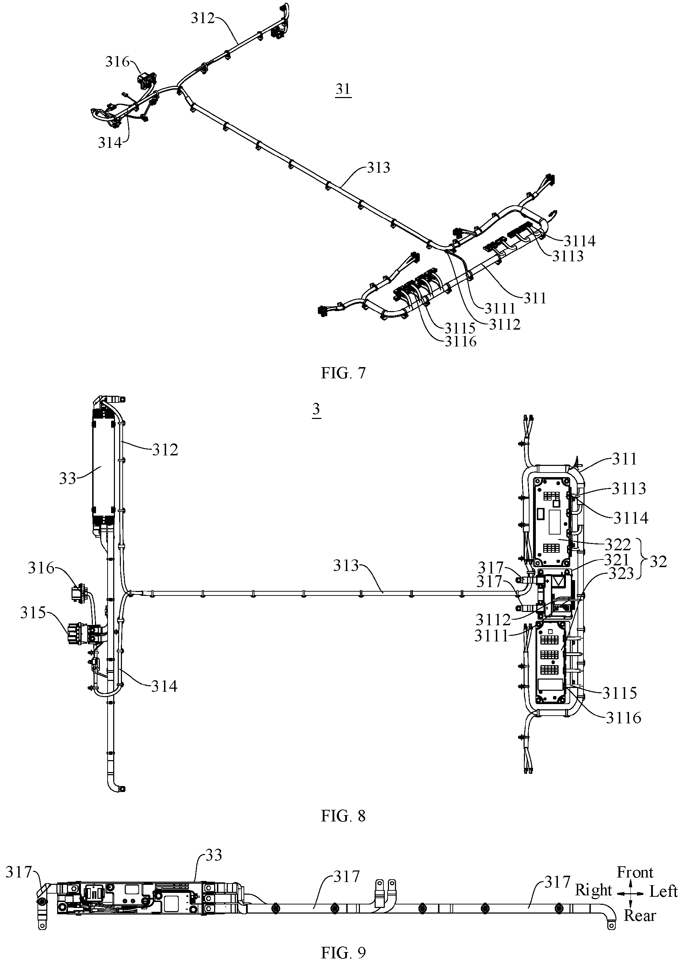

In an embodiment of the present disclosure, the BMS main control board 322 and the BMS slave control board 323 realize the functions of high-voltage on-off and safety protection by controlling the first BDU unit 321 and the second BDU unit. The BMS main control board 322 is in communication connection with the BMS slave control board 323 through a wiring harness of the electrical connection structure 31. The BMS main control board 322 and the BMS slave control board 323 are in communication connection with the first BDU unit 321 and the second BDU unit through the wiring harness of the electrical connection structure 31. The first BDU unit 321 is located in a middle of the battery group 2 in the second direction D2. The second BDU unit is connected to the battery group 2 through a copper busbar 317. In the electronic control structure 32, the BMS main control board 322, the first BDU unit 321, and the BMS slave control board 323 are sequentially arranged in the second direction D2. The wiring harness part of the electrical connection structure 31 is shown in FIG. 7 and consists of a plurality of wiring harnesses.

By disposing the first BDU unit 321 between the BMS main control board 322 and the BMS slave control board 323, a central arrangement of the first BDU unit 321 is facilitated, which facilitates a symmetrical connection between the first BDU unit 321 and the battery group 2. When voltage division protection is required for the battery group 2, the first BDU unit 321 is symmetrical to two battery sub-groups 20 of the battery group 2.

In an embodiment of the present disclosure, the BMS main control board 322 and the BMS slave control board 323 are detachably disposed through the side access opening 101. It can be understood that in terms of failure frequency, the BMS main control board 322 and the BMS slave control board 323 both have higher failure rates. Therefore, the BMS main control board 322 and the BMS slave control board 323 are configured to be detachably connected to facilitate direct removal for maintenance and inspection in case of failure.

Exemplarily, the first electrical module 3 includes at least one BMS slave control board 323. The BMS slave control board 323 may collect and transmit battery cell data of the battery group 2, and transmit the data to the BMS main control board 322 through the electrical connection structure 31. Thus, the number of BMS slave control boards 323 can be set based on the number of battery cells 201 in the battery group 2.

In an embodiment of the present disclosure, two BMS slave control boards 32 are provided and stacked in the height direction. A dimension of each of the BMS slave control boards 323 in the first direction D1 is 86.5 mm, a dimension of each of the BMS slave control boards 323 in the second direction D2 is 240 mm, and a height dimension of each of the BMS slave control boards 323 is 19.7 mm. A stacked height of the two BMS slave control boards 323 is 48.7 mm. A dimension of the BMS main control board 322 in the first direction D1 is 102 mm, a dimension of the BMS main control board 322 in the second direction D2 is 260 mm, and a height dimension of the BMS main control board 322 is 24 mm. A dimension of the first BDU unit 321 in the first direction D1 is 103 mm, a dimension of the first BDU unit 321 in the second direction D2 is 153 mm, and a height dimension of the first BDU unit 321 is 85.5 mm. In the second direction D2, the dimensions of the BMS slave control board 323, the BMS main control board 322, and the first BDU unit 321 in the electronic control structure 321 are at least 653 mm.

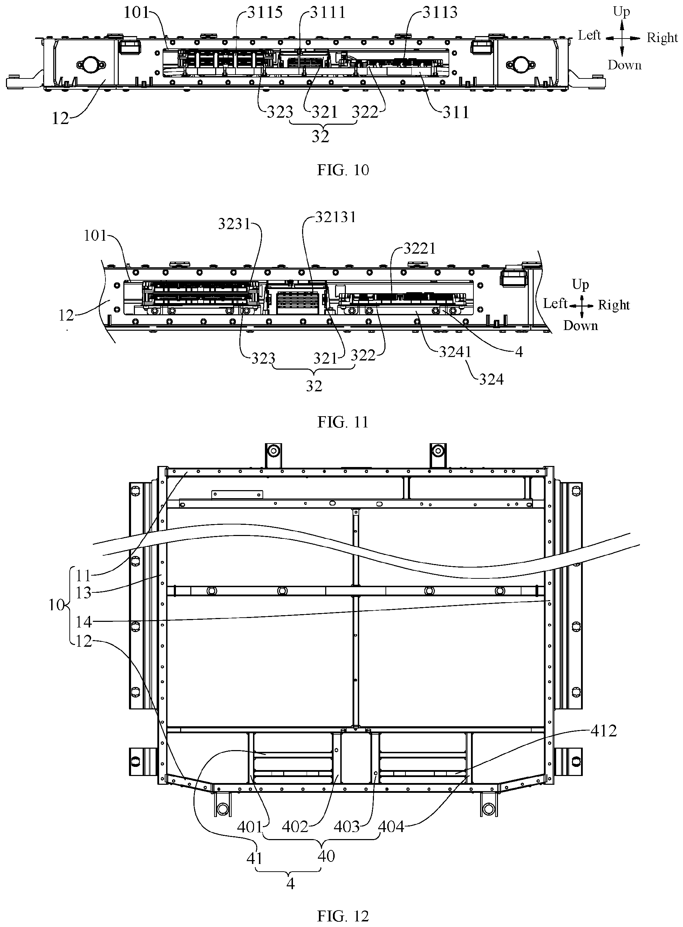

As shown in FIG. 10 and FIG. 11, a height dimension of each of the electronic control structure 321 and the second electrical portion 302 is lower than the height dimension of the battery group 2.

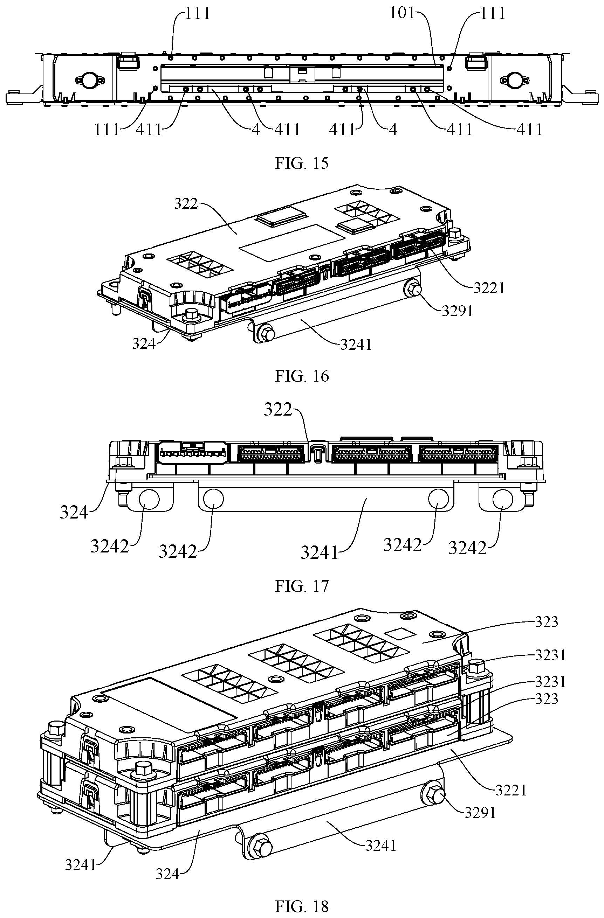

In some specific embodiments, as shown in FIG. 17, FIG. 18, and FIG. 11, the BMS slave control boards 323 are arranged in the left-right direction. At least two BMS slave control boards 323 are provided and stacked in the height direction. Projections of all the BMS slave control boards 323 on the rear side wall 12 are completely located within the coverage of the side access opening 101. In this way, the BMS slave control boards 323 can be directly pulled out or inserted in the horizontal direction during disassembly and assembly, reducing collisions caused by tilting. Moreover, when the side access opening 101 is open, states of the BMS slave control boards 323 can also be observed intuitively even without taking out the BMS slave control boards 323.

As shown in FIG. 18, FIG. 19, and FIG. 11, the BMS main control board 322 is arranged in the left-right direction, and a projection of the BMS main control board 322 on the rear side wall 12 is completely located within the coverage of the side access opening 101. In this way, the BMS main control board 322 can be directly pulled out or inserted in the horizontal direction during disassembly and assembly, reducing collisions caused by tilting. Moreover, when the side access opening 101 is open, a state of the BMS main control board 322 can also be observed intuitively even without taking out the BMS main control board 322.

In some embodiments, as shown in FIG. 12 to FIG. 14, the battery pack 100 further includes a support frame 4 located in the casing 1. The electronic control structure 32 is mounted at the support frame 4. The support frame 4 may provide the electronic control structure 32 with a supporting force, which reduces shaking of the electronic control structure 32 during a movement of the battery pack 100, thus improving safety of the battery pack 100. In addition, the arrangement of the support frame 4 can also lift the electronic control structure 32 to facilitate its alignment with the side access opening 101.

A side of the support frame 4 facing the side access opening 101 has a plurality of first threaded holes 411 that are distributed sequentially in the second direction D2. The BMS main control board 322 and the BMS slave control board 323 may be directly or indirectly connected to the support frame 4 by bolts, and be connected to the first threaded holes 411 for easy disassembly and assembly.

In some embodiments, the electronic control structure 32 includes two mounting plates 324. The BMS main control board 322 and the BMS slave control board 323 are mounted on their respective mounting plates 324, respectively. The mounting plates 324 are fixed in the casing 1 by first bolts 3291. Each of the first bolts 3291 is arranged in the front-rear direction and has a head located at its rear end. Projections of the first bolts 3291 on the rear side wall 12 are located within the coverage of the side access opening 101.

In an embodiment of the present disclosure, as shown in FIG. 16, the BMS main control board 322 is connected to one of the mounting plates 324, for example, as shown in the drawing, is fixedly connected to the one mounting plate 324 by vertically arranged bolts.

In an embodiment of the present disclosure, as shown in FIG. 18, the BMS slave control board 323 is connected to the other mounting plate 324, for example, as shown in the drawing, is fixedly connected to the other mounting plate 324 by vertically arranged bolts.

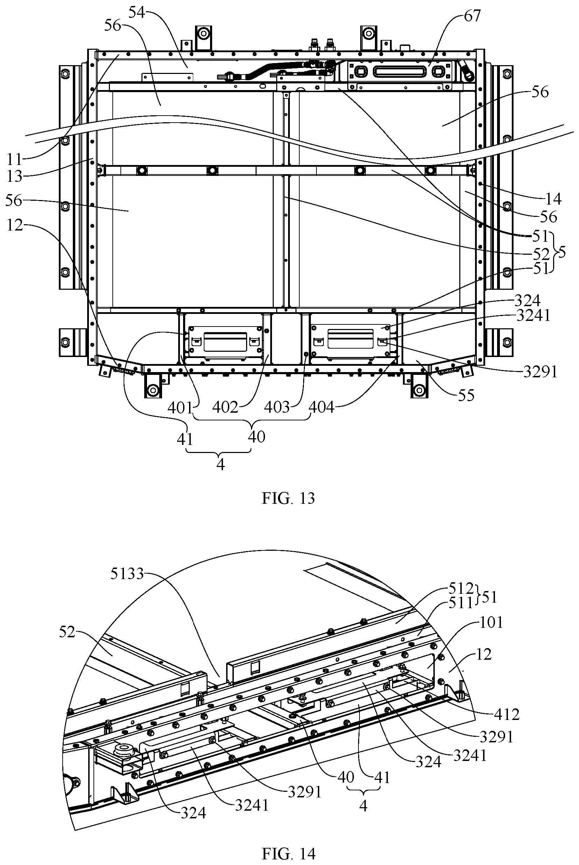

In an embodiment of the present disclosure, as shown in FIG. 13 and FIG. 14, during assembly, the mounting plate 324 with the BMS main control board 322 or the BMS slave control board 323 is placed at the support frame 4, and a side of the mounting plate 324 facing the side access opening 101 is formed with a downwardly extending flange 3241. The flange 3241 has mounting holes 3242 corresponding to the first threaded holes 411, and the first bolts 34 pass through the mounting holes 3242 and the first threaded holes 411 sequentially for fixation.

As shown in FIG. 12 to FIG. 14, the support frame 4 includes four support cross rods 41 distributed in the first direction D1. Each support cross rod 41 extends in the second direction D2. Two of the support cross rods 41 are close to the side access opening 101, and the other two support cross rods 41 are away from the side access opening 101. Each support cross rod 41 has a first threaded hole 411 formed thereon. Moreover, each of the support cross rods 41 close to the side access opening 101 has an avoidance groove 412 corresponding to the first threaded hole 411 away from the side access opening 101.

The mounting plate 324 is provided with two flanges 3241 distributed in the first direction D1, and each flange 3241 has a mounting hole 3242 formed thereon. The mounting plate 324 is placed at the support frame 4, and has a downwardly extending flange 3241 formed at a side of the mounting plate 324 facing the side access opening 101. The flange 3241 has a mounting hole 3242 corresponding to the first threaded hole 411. The first bolt 34 may pass through the mounting hole 3242 and the first threaded hole 411 sequentially to realize fixation between the mounting plate 324 and the support frame 4. Moreover, the first bolt 34 is disposed at the support frame 4 in the second direction D2, which can reduce interference during disassembly and assembly and improve efficiency of mounting or disassembly. Moreover, the flange 3241 may also position mounting position of the mounting plate 324 and assist in the fixation between the mounting plate 324 and the support frame 4. The flange 3241 of the mounting plate 324 faces the side access opening 101 and extends downward. The flange 3241 is an integral long strip, and has a mounting hole 3242 formed at a position corresponding to the first threaded hole 411. Alternatively, the flange 3241 is a long strip having an avoidance groove 412, and is disposed at the position corresponding to the first threaded hole 411.

In some specific embodiments, as shown in FIG. 12 and FIG. 13, the support frame 4 further includes four support longitudinal rods 40. Each support longitudinal rod 40 extends in the first direction D1. The four support longitudinal rods 40 are a first longitudinal rod 401, a second longitudinal rod 402, a third longitudinal rod 403, and a fourth longitudinal rod 404 arranged sequentially. A support cross rod 41 is connected between the first longitudinal rod 401 and the second longitudinal rod 402. A support cross rod 41 is connected between the third longitudinal rod 403 and the fourth longitudinal rod 404.

The electronic control structure 32 includes two detachable components respectively located at the support cross rods 41 at the two sides. Thus, the support longitudinal rods 40 and the support cross rods 41 in the support frame 4 can support the detachable components. By configuring the support frame 4 as a combination of the support longitudinal rods 40 and the support cross rods 41, compared with configuring the support frame 4 as an integral support plate, on the one hand, the support longitudinal rods 40 are light in weight, which can reduce a weight of the entire battery pack 100 while meeting a structural strength. On the other hand, production and manufacturing processes of the support rods 40 are simple, which can reduce production costs and improve production efficiency.

In an embodiment of the present disclosure, two support cross rod 41 is connected between the first longitudinal rod 401 and the second longitudinal rod 402, and are arranged in the first direction D1. Each support cross rod 41 has a mounting hole 3242 formed thereon. A support cross rod 41 close to the front in the first direction D1 is a first support cross rod, and a support cross rod 41 close to the rear in the first direction D1 is a second support cross rod. A height dimension of the second support cross rod is partially higher than a height dimension of the first support cross rod 41, and the mounting hole 3242 at the second support cross rod may be completely exposed. At the mounting hole 3242, the height dimensions of the first support cross rod and the second support cross rod are the same.

Further, the BMS slave control board 323 is detachably connected to the first longitudinal rod 401 and the second longitudinal rod 402 through one of the mounting plates 324, and the BMS main control board 322 is detachably connected to the third longitudinal rod 403 and the fourth longitudinal rod 404 through the other mounting plate 324.

Further, the first BDU unit 321 may be mounted at the second longitudinal rod 402 and the third longitudinal rod 403. For example, the first BDU unit 321 includes a first electrical housing 3011 connected to the second longitudinal rod 402 and the third longitudinal rod 403 through vertically arranged bolts.

In some embodiments, as shown in FIG. 10, FIG. 20, and FIG. 21, the first BDU unit 321 includes a first electrical housing 3211 and a fuse 3212. The first electrical housing 3211 has a first opening 3211a facing the side access opening 101. In an embodiment of the present disclosure, the first electrical housing 3211 has a first opening 3211a formed at a rear side of the first electrical housing 3211. The fuse 3212 is detachably disposed in the first electrical housing 3211.

In an embodiment of the present disclosure, the fuse 3013 is detachably connected to the first electrical housing 3011. After the electrical connection is cut off when the battery pack 100 fails, the fuse 3013 needs to be replaced or manually reset.

In an embodiment of the present disclosure, the first BDU unit 321 further includes a side protection cover 3217 detachably covering the first opening 3211a. By providing the first electrical housing 3211 and the side protection cover 3217, on the one hand, internal electrical components of the first BDU unit 321, such as the fuse 3212, can be protected. On the other hand, the internal electrical components, such as the fuse 3212, are disposed in the first electrical housing 3211, which realizes fixation and mounting of the internal electrical components and improves convenience and reliability of the fixed connection.

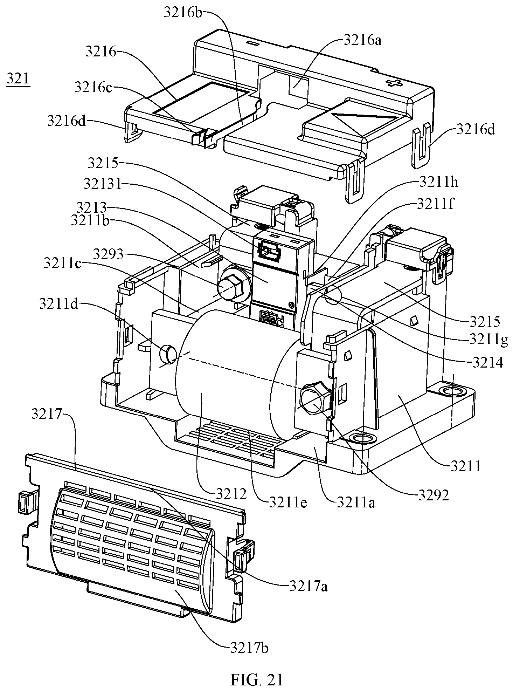

Further, as shown in FIG. 21, each of two ends of the side protection cover 3217 is provided with a second snap-fit portion 3217a. The side protection cover 3217 may be in a snap-fit connection with the first electrical housing 3211 through the second snap-fit portions 3217a.

In some specific embodiments, as shown in FIG. 21, the side protection cover 3217 includes an arc-shaped plate 3217b located between the second snap-fit portions 3217a at the two sides of the side protection cover 3217, and has a shape matching the fuse 3212, which improves compactness and constraint on the fuse 3212. The arc-shaped plate 3217b may be a circular arc plate. In an embodiment of the present disclosure, the arc-shaped plate 3217b is a grid plate to improve a heat dissipation effect. By providing the second snap-fit portions 3217a for connection, connection stability and convenience are improved. By configuring the side protection cover 3217 as a circular arc grid plate, a structural strength of the side protection cover 3217 can be improved.

In an embodiment of the present disclosure, the first BDU unit 321 further includes a current sensor 3213 connected in series with the fuse 3212 and detachably disposed in the first electrical housing 3211. In this way, the current sensor 3213 can timely detect a current passing through the fuse 3212, to allow the BMS slave control board 323 to timely determine whether the fuse 3212 needs to be blown.

Internal circuit structures and specific working principles of the fuse 3212, the current sensor 3213, the BMS main control board 322, and the BMS slave control board 323 are each related art, and are omitted here.

In an embodiment of the present disclosure, as shown in FIG. 21, the fuse 3212 is fixed on the first electrical housing 3211 by a second bolt 3292. A head of the second bolt 3292 directly faces the side access opening 101. A projection of the second bolt 3292 on the rear side wall 12 is located within the coverage of the side access opening 101. Thus, reliability and stability of the connection of the fuse 3212 to the first electrical casing 1 are improved.

When the fuse 3212 fails and needs to be replaced, the second snap-fit portion 3217a is unlocked to separate the side protection cover 3217 from the first electrical housing 3211 to expose the second bolt 3292. Then, the second bolt 3292 is unscrewed to release the fixed connection between the fuse 3212 and the first electrical housing 3211. Finally, the faulty fuse 3212 is taken out through the side access opening 101.

Similarly, the current sensor 3213 is fixed on the first electrical housing 3211 by a third bolt 3293. A head of the third bolt 3293 is arranged facing the side access opening 101. A projection of the third bolt 3293 on the rear side wall 12 is located within the coverage of the side access opening 101. Thus, reliability and stability of the connection of the current sensor 3213 to the first electrical housing 1 are improved.

When the current sensor 3213 fails and needs to be replaced, the second snap-fit portion 3217a is unlocked to separate the side protection cover 3217 from the first electrical housing 3211 to expose the third bolt 3293. Then, the third bolt 3293 is unscrewed to release the fixed connection between the current sensor 3213 and the first electrical housing 3211. Finally, the faulty current sensor 3213 is taken out through the side access opening 101.

In some embodiments, as shown in FIG. 21, the first electrical housing 3211 is internally provided with a first positioning cavity 3211e and a second positioning cavity 3211h that are opened towards the side access opening 101. The fuse 3212 is located in the first positioning cavity 3211e, and the current sensor 3213 is located in the second positioning cavity 3211h. In this way, the first positioning cavity 3211e and the second positioning cavity 3211h are used to respectively position the fuse 3212 and the current sensor 3213, facilitating assembly.

In an embodiment of the present disclosure, the first electrical housing 3211 is internally formed with a first positioning protuberance 3211c on at least one side of the first positioning cavity 3211e, and an end of the fuse 3212 is detachably connected to the first positioning protuberance 3211c. The fuse 3212 is fixedly connected at a side of the first positioning cavity 3211e, which causes less obstruction to the fuse 3212.

The first electrical housing 3211 is internally formed with a second positioning protuberance 3211f on at least one side of the second positioning cavity 3211h, and an end of the current sensor 3213 is detachably connected to the second positioning protuberance 3211f. The current sensor 3213 is fixedly connected at the side of the second positioning cavity 3211h, which causes less obstruction to the current sensor 3213.

Further, a threaded hole is formed at each of a surface of the first positioning protuberance 3211c facing the side access opening 101 and a surface of the second positioning protuberance 3211f facing the side access opening 101. The fuse 3212 is connected to the first positioning protuberance 3211c by bolts. The current sensor 3213 is connected to the second positioning protuberance 3211f by bolts. The bolt connection is convenient and fast, and does not affect the line of sight.

In some specific embodiments, as shown in FIG. 21, the first electrical housing 3211 is internally provided with two first positioning protuberances 3211c. A rear surface of each of the first positioning protuberances 3211c has a second threaded hole 3211d. The first positioning cavity 3211e is defined between the two first positioning protuberances 3211c. The fuse 3212 is located in the first positioning cavity 3211e. Two ends of the fuse 3212 are connected to the two first positioning protuberances 3211c through the second bolts 3292. Each second bolt 3292 is threadedly engaged with the corresponding second threaded hole 3211d.

The first electrical housing 3211 is provided with two second positioning protuberances 3211f. A rear surface of each of the two second positioning protuberances 3211f has a third threaded hole 3211g. The second positioning cavity 3211h is defined between the two second positioning protuberances 3211f. The current sensor 3213 is located in the second positioning cavity 3211h. Two ends of the current sensor 3213 are connected to the two second positioning protuberances 3211f through the third bolts 3293. Each third bolt 3293 is threadedly engaged with the corresponding third threaded hole 3211g.

In this way, both the fuse 3212 and the current sensor 3213 are accurately positioned, and it is helpful to structure compactness.

In an embodiment of the present disclosure, the first positioning protuberance 3211c and the second positioning protuberance 3211f are staggered in height and are at different distances from the side access opening 101.

Further, the two first positioning protuberances 3211c are arranged in the left-right direction, and the two second positioning protuberances 3211f are arranged in the left-right direction. The two second positioning protuberances 3211f and the two first positioning protuberances 3211c are different in height. Moreover, the rear surface of the first positioning protuberance 3211c and the rear surface of the second positioning protuberance 3211f are staggered in the front-rear direction. This arrangement is intended to provide front-rear staggering of the fuse 3212 and the current sensor 3213 during disassembly and assembly, which is beneficial to a reduction in the dimensions of the first BDU unit 321 in the height direction and the front-rear direction.

In an embodiment of the present disclosure, the first positioning protuberance 3211c is located below the second positioning protuberance 3211f, so that the fuse 3212 is mounted below the current sensor 3213. In addition, the fuse 3212 is located at a rear side of the current sensor 3213, and closer to the side access opening 101. In terms of failure frequency, this arrangement makes a fuse 3212 having a higher failure rate easier to remove.

Advantageously, as shown in FIG. 21, the first BDU unit 321 further includes a first conductive sheet 3214 located in the first positioning cavity 3211e at a front side of the fuse 3212. The first conductive sheet 3214 is located at a side of the fuse 3212 away from the side access opening 101. One of the second positioning protuberances 3211f is located directly above corresponding one of the first positioning protuberances 3211c, and a dimension of the current sensor 3213 in the left-right direction is smaller than a dimension of the fuse 3212 in the left-right direction. A part of a side edge of the first conductive sheet 3214 extends laterally and is bent to be connected to the one first positioning protuberance 3211c for electrical connection with the fuse 3212. A part of an upper edge of the first conductive sheet 3214 extends upward and is bent to be connected to the other second positioning protuberance 3211f for electrical connection with the current sensor 3213.

This arrangement uses the first conductive sheet 3214 to connect the fuse 3212 and the current sensor 3213 in series. Moreover, the first conductive sheet 3214 is not easy to disengage, with high reliability. A width of the first conductive sheet 3214 may be set to be relatively large, which is beneficial to a reduction in resistance and the like.

In an embodiment of the present disclosure, as shown in FIG. 21, the first electrical housing 3211 has a second opening 3211b at a top of the first electrical housing 3211. The first BDU unit 321 further includes a top protection cover 3216 and two second conductive sheets 3215. The two second conductive sheets 3215 are spaced apart from each other in the left-right direction and disposed at the top of the first electrical housing 3211, and each second conductive sheet 3215 extends in the front-rear direction.

A rear end of one of the second conductive sheets 3215 is bent downward to rest on one of the first positioning protuberances 3211c to be electrically connected to the fuse 3212. A rear end of the other second conductive sheet 3215 is bent downward to rest on one of the second positioning protuberances 3211f to be electrically connected to the current sensor 3213. A front end of each of the two second conductive sheets 3215 is connected to the battery group 2 through the copper busbar 317. The top protection cover 3216 is detachably connected to the top of the first electrical housing 3211 and covers the two second conductive sheets 3215.

The arrangement of the top protection cover 3216 not only facilitates disassembly, assembly, and maintenance, but also provides a certain degree of position constraint on the second conductive sheets 3215. This arrangement results in high electrical reliability and more flexible component replacement.

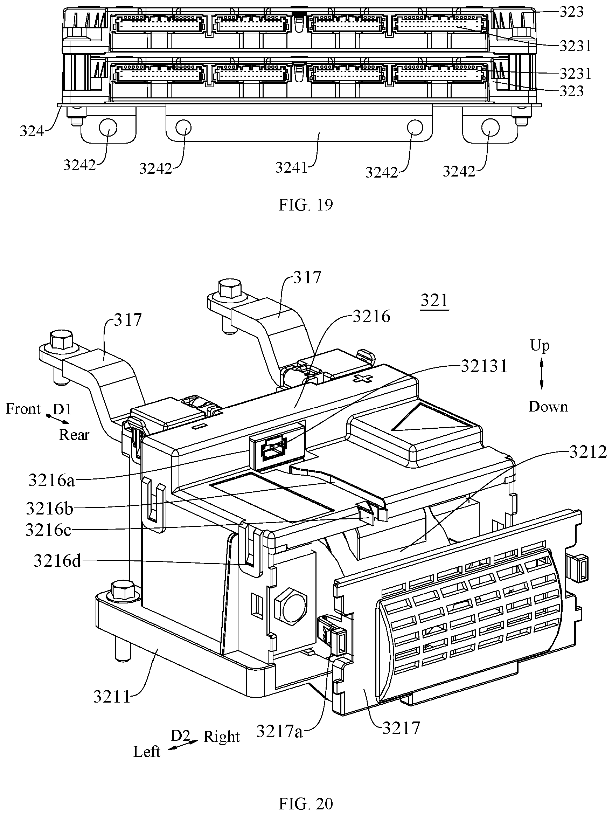

In an embodiment of the present disclosure, as shown in FIG. 20 and FIG. 21, the current sensor 3213 has a first plug interface 32131 at the rear side of the current sensor 3213, and the top protection cover 3216 has a first through-hole 3216a directly facing the first plug interface 32131.

As shown in FIG. 7 and FIG. 8, the electrical connection structure 31 includes a first flexible wire 3111 located at a rear side of the first BDU unit 321. An end of the first flexible wire 3111 is provided with a first plug connector 3112. The first plug connector 3112 is inserted and engaged into the first plug interface 32131 through the first through-hole 3216a.

In this way, during disassembly and assembly, the first plug connector 3112 can be directly unplugged from the side access opening 101. The first flexible wire 3111 is pulled aside, and then an internal structure of the first BDU unit 321 is inspected or disassembled and assembled. After the assembly is completed, the first plug connector 3112 is directly inserted from the rear side, making the assembly very convenient and reducing interference of messy wires.

In an embodiment of the present disclosure, as shown in FIG. 20 and FIG. 21, a top surface of the top protection cover 3216 has a limiting slot 3216b extending in the front-rear direction. A front end of the limiting slot 3216b is arranged facing the first through-hole 3216a, and a part of the first flexible wire 3111 is located in the limiting slot 3216b. The limiting slot 3216b can realize constraint on the first flexible wire 3111, and reduce shaking of the first flexible wire 3111 during vibration and a probability of loosening caused by shaking. Moreover, compared with other wires, the first flexible wire 3111 is thinner and lighter in weight, which can improve connection reliability and thus enhance the safety of the battery pack 100 during use.

In an embodiment of the present disclosure, the top protection cover 3216 is further provided with a limiting protrusion 3216c on at least one side of the limiting slot 3216b, which can further constrain the first flexible wire 3111 and improve safety of the first flexible wire 3111 during use. Further, as shown in FIG. 21, the top protection cover 3216 is provided with two limiting protrusions 3216c having barbs at their ends, to facilitate hooking the first flexible wire 3111.

Further, as shown in FIG. 21, each of two ends of the top protection cover 3216 is provided with a first snap-fit portion 3216d. The top protection cover 3216 may be in a snap-fit connection with the first electrical housing 3211 through the first snap-fit portion 3216d. By providing the first snap-fit portion 3216d for connection, connection stability and convenience are improved.

In some embodiments, as shown in FIG. 7, FIG. 8, and FIG. 10, the BMS main control board 322 has a second plug interface 3221 at a rear side of the BMS main control board 322, and the BMS slave control board 323 has a third plug interface 3231 at a rear side of the BMS slave control board 323. The electrical connection structure 31 further includes a second flexible wire 3113 located at the rear side of the BMS main control board 322. An end of the second flexible wire 3113 is provided with a second plug connector 3114 engaged into the second plug interface 3221.

The electrical connection structure 31 further includes a third flexible wire 3115 located at the rear side of the BMS slave control board 323. An end of the third flexible wire 3115 is provided with a third plug connector 3116 engaged into the third plug interface 3231.

This arrangement can allow the second plug connector 3114 and the third plug connector 3116 to be directly unplugged from the side access opening 101 during disassembly and assembly. The second flexible wire 3113 is pulled aside, to allow a structure of the BMS main control board 322 to be inspected or disassembled and assembled. The third flexible wire 3115 is pulled aside, to allow a structure of the BMS slave control board 323 to be inspected or disassembled and assembled.

After assembly is completed, the second plug connector 3114 and the third plug connector 3116 are directly inserted from the rear side, making the assembly very convenient and reducing the interference of messy wires.

As shown in FIG. 6 and FIG. 8, in some embodiments, the electrical connection structure 31 includes a first wiring harness 311 arranged around the electronic control structure 32 and electrically connected to the battery group 2. The first wiring harness 311 is provided with plug connectors that are inserted into and connected with the BMS main control board 302, the BMS slave control board 303, and the first BDU unit 321, respectively. The plug connectors are located at a side of the electronic control structure 32 facing the side access opening 101. The first wiring harness 311 is arranged around the electronic control structure 32, which can change insertion directions of the plug connectors on the first wiring harness 311 to face the side access opening 101. Thus, the first wiring harness 311 can be more easily pulled aside through the side access opening 101, further improving maintenance convenience.

In an embodiment of the present disclosure, the first flexible wire 3111, the second flexible wire 3113, and the third flexible wire 3115 are each led out from the first wiring harness 311.

In an embodiment of the present disclosure, the first wiring harness 311 is provided with a plurality of wiring harness snaps arranged at intervals in an extending direction of the first wiring harness 311, and a disassembly and assembly direction of the wiring harness snaps faces the side access opening 101. The first wiring harness 311 can be fixed by the plurality of wiring harness snaps, reducing swing of the first wiring harness 311 and a probability of loosening the insertion of the plug connectors on the first wiring harness 311.

In some embodiments, as shown in FIG. 1 and FIG. 3, the battery pack 100 further includes a side access cover 64. The side access cover 64 may cover the side access opening 101, and is openably and closably connected to the rear side wall 12. The side access cover 64 can protect the internal structure of the battery pack 100, preventing dust, moisture, and the like from entering the battery pack 100 through the side access opening 101.

In an embodiment of the present disclosure, as shown in FIG. 15, the rear side wall 12 has a plurality of first fixing holes 111 arranged at intervals in a circumferential direction of the side access opening 101. The side access cover 64 may cover the side access opening 101, and has a plurality of through holes corresponding to positions of the first fixing holes 111. The first fixing holes 111 and the through holes are connected by fasteners to improve connection stability.

Alternatively, the side access cover 64 is connected to the rear side wall 12. A side edge of the side access cover 64 may be rotated with respect to the rear side wall 12, and other side edges of the side access cover 64 have through holes corresponding to the fixing holes of the rear side wall 12. The through holes and the fixing holes are connected by the fasteners.

In an embodiment of the present disclosure, a dimension of the side access opening 101 in the second direction D2 is 720 mm, and a height dimension of the side access opening 101 is 70 mm. A height dimension of the electronic control structure 32 is smaller than the height dimension of the side access opening 101. Thus, the BMS main control board 322, the BMS slave control boards 323, and the first BDU unit 321 in the electronic control structure 32 can pass through the side access opening 101, respectively.

In an embodiment of the present disclosure, when one of the BMS main control board 322, the BMS slave control board 323, and the first BDU unit 321 needs to be replaced, the fasteners in the first fixing holes 111 are released, and the side access cover 64 is removed. Moreover, the wiring harness snaps 91 may be disassembled one by one through the first access opening 12. The plug connectors are removed, and the faulty electrical component is removed through the side access opening 101.

In some embodiments, as shown in FIG. 7 and FIG. 8, the electrical connection structure 31 includes a second wiring harness 312, a third wiring harness 313, and a fourth wiring harness 314. The second wiring harness 312 is arranged in a length direction of the second electrical portion 33, and is detachably connected to at least one end of the second electrical portion 33, which allows the electrical connection structure 31 to be electrically connected to the second electrical portion 33.

The third wiring harness 313 is connected between the first wiring harness 311 and the second wiring harness 312, which allows for communication between the electronic control structure 32 and the second electrical portion 33. The fourth wiring harness 314 is connected to the third wiring harness 313, and an end of the fourth wiring harness 314 is provided with a low-voltage electrical terminal 316. Through the low-voltage electrical terminal 316 of the fourth wiring harness 314, the battery pack 100 can perform signal transmission with devices outside the battery pack 100.

In some embodiments, as shown in FIG. 13 and FIG. 6, the battery pack 100 further includes a partition assembly 5 disposed in the casing 1. The partition assembly 5 includes at least three cross beams 51 extending in the left-right direction. The at least three cross beams 51 are arranged at intervals in the front-rear direction.

The battery group 2 is located between a foremost cross beam 51 and a rearmost cross beam 51. The front cavity 54 is defined between the foremost cross beam 51 and the front side wall 11, and the second electrical portion 33 is located in the front cavity 54. The rear cavity 55 is defined between the rearmost cross beam 51 and the rear side wall 12, and the electronic control structure 32 is located in the rear cavity 55.

The at least three cross beams 51 are arranged to divide the interior of the casing 1 of the battery pack 100 into regions, which not only improves the structural strength of the battery pack 100, but also provides a mounting position for the internal structure. In addition, the arrangement of the at least three cross beams 51 can also limit a discharge direction of internal fluid.

In an embodiment of the present disclosure, the partition assembly 5 further includes at least two longitudinal beams 52 extending in the front-rear direction. One of the longitudinal beams 52 is connected between every two adjacent cross beams 51. One of the receiving sub-cavities 56 is defined by two adjacent cross beams 51, one of the longitudinal beams 52, and the side wall of the casing 1. The battery group 2 includes a plurality of battery sub-groups 20. One battery sub-group 20 is received in each receiving sub-cavity 56.

In FIG. 3 and FIG. 4, the battery group 2 includes four battery sub-groups 20 each located in one of the receiving sub-cavities 56.

In some specific embodiments, as shown in FIG. 14 and FIG. 6, each cross beam 51 includes a lower cross bar 511 and an upper cross bar 512. The lower cross bar 511 extends in the left-right direction. Two ends of the lower cross bar 511 are connected to the left side wall 13 and the right side wall 14 of the casing 1, respectively. The upper cross bar 512 extends in the left-right direction, and is fixedly connected above the lower cross bar 511. Each lower cross bar 511 is connected to at least two upper cross bars 512 spaced apart from each other.

For the same cross beam 51, a first notch 5131 is defined between a left upper cross bar 512 and the left side wall 13 of the casing 1, a second notch 5132 is defined between a right upper cross bar 512 and the right side wall 14 of the casing 1, and a third notch 5133 is defined between two adjacent upper cross bars 512. One third notch 5133 is provided above a connection between two adjacent longitudinal beams 52.

This solution of overlapping the horizontal and longitudinal beams can not only facilitate mounting, but can also support the third wiring harness 313 when the third wiring harness 313 passes through the battery group 2. This solution not only improves orderliness of wiring, but also avoids the need to insert the third wiring harness 313 into the receiving sub-cavity 56, reducing a probability of a pressure relief member 202 spraying an internal electrolyte towards the third wiring harness 313, thus reducing a risk of a short circuit or open circuit of the third wiring harness 313 due to this reduced probability.

In an embodiment of the present disclosure, the third wiring harness 313 is bound to the longitudinal beam 52 through the wiring harness snap, which reduces shaking of the third wiring harness 313 during vibration and the probability of loosening caused by shaking.

In some specific embodiments, as shown in FIG. 6 and FIG. 8, the first wiring harness 311 is located in the rear cavity 55 and arranged around the electronic control structure 32. The first wiring harness 311 is electrically connected to the battery group 2, and is detachably and electrically connected to the electronic control structure 32. The second wiring harness 312 is located in the front cavity 54 and arranged in the left-right direction at a rear side of the second electrical portion 33. The second wiring harness 312 is detachably and electrically connected to the second electrical portion 33. In this way, the first wiring harness 311 and the second wiring harness 312 are each constrained, reducing shaking and a risk of connection loosening caused by shaking.

Further, as shown in FIG. 6, the battery pack 100 further includes at least one seat mounting nut 53 configured to be connected to an external seat. The seat mounting nut 53 is fixedly connected to at least one cross beam 51. At least two seat mounting nuts 53 are arranged at intervals in the left-right direction on the at least one cross beam 51. In this way, when the battery pack 100 is applied in the vehicle 1000, a seat in a passenger space 220 may be engaged with the seat mounting nut 53 through the fastener. Therefore, there is no need to additionally arrange a seat mounting cross beam in the passenger space 220, improving structural compactness and reducing the number of parts.

In an embodiment of the present disclosure, as shown in FIG. 6 and FIG. 1, a height of the cross beam 51 is smaller than a height of the casing 1. The seat mounting nuts 53 are connected to a top of the cross beam 51 through welding. The top plate 16 of the casing 1 is provided with a seat fixing fastener 66 directly facing each seat mounting nut 53. In this way, the seat can be connected to each of the seat fixing fastener 66 and the seat mounting nut 53 through fasteners, realizing extension of a matching length in a vertical direction. Moreover, when the seat is stressed, an acting force is transmitted to the entire battery pack 100, and an impact force is dispersed by the entire battery pack 100.

In some specific embodiments, as shown in FIG. 2, a battery cell 201 in the battery sub-groups 20 is arranged in the left-right direction, and is provided with a pressure relief member 202 at a left end and/or right end of the battery cell 201. In an example of FIG. 2, each battery cell 201 in each battery sub-group 20 is provided with the pressure relief member 202 to improve its safety. The number of pressure relief members 202 on each battery cell 201 may be one or more, which is not limited here.

In an embodiment of the present disclosure, the battery cell 201 is in a sheet-like shape and extends in the second direction D2. A plurality of battery cells 201 are stacked in the first direction D1 to form one battery sub-group 20. Therefore, it is beneficial to an improvement in an arrangement density of the battery sub-groups 20 and an energy density of the battery pack 100.

A flow passage 561 is formed between each of the left and right ends of the battery sub-group 20 and an inner wall of the receiving sub-cavity 56. In this way, there is no need to provide another passage. The passage between the end of the battery sub-group 20 and the inner wall of the receiving sub-cavity 56 is used to discharge high-pressure gas discharged by the pressure relief member 202, which improves the utilization rate of the internal space. The flow passage 561 may also serve as a buffer channel for the battery sub-group 20.

In an embodiment of the present disclosure, a width x1 of the flow passage 561 ranges from 5 mm to 50 mm. Thus, flowability of the flow passage 561 is effectively ensured. Moreover, the width x1 of the flow passage 561 does not occupy excessive volume due to being overly wide. In an embodiment of the present disclosure, the width x1 of the flow passage 561 is 35 mm. The width x1 of the flow passage 561 refers to a dimension of the flow passage 561 in the second direction D2.

In an embodiment of the present disclosure, as shown in FIG. 5, the rear side wall 12 of the casing 1 is provided with an exhaust port 102, so that the discharged high-pressure gas can be discharged from the exhaust port 102. Further, in an embodiment of the present disclosure, as shown in FIG. 5, the air pressure balance valve 65 is provided at the exhaust port 102. In this way, the air pressure balance valve 65 is switched on to discharge air when a high-pressure air flow is discharged inside the casing 1, and remains closed when air pressure is normal.

In some embodiments, as shown in FIG. 6, the high-voltage electrical terminal 315 and the low-voltage electrical terminal 316 are mounted at the front side wall 11 of the casing 1 and spaced apart from the second electrical portion 33 in the left-right direction. The rear side wall 12 of the casing 1 is provided with the exhaust port 102. This arrangement allows a position of the battery pack 100 for external power connection and communication does not interfere with the side access opening 101 located at front and rear sides of the battery pack 100. When the battery pack 100 is mounted on the vehicle 1000, since the electrical connection and communication part has a low failure rate, the part is placed at the front side and protected inside the vehicle body 200, which can further reduce its failure rate.

The second electrical portion 33 is adjacent to and arranged along the front side wall 11. The high-voltage electrical terminal 315 of the electrical module 3 may output the high-voltage electricity to the outside of the battery pack 100 to provide electrical energy. The low-voltage electrical terminal 316 of the electrical module 3 may output the low-voltage electricity to the outside of the battery pack 100 to transmit signals. The electrical connection structure 31 is connected to the second electrical portion 33, the low-voltage electrical terminal 316, and the high-voltage electrical terminal 315, and its mounting position is close to the front side wall 11, which can reduce the arrangement of the electrical connection structure 31 and the application costs of the electrical connections.

In some embodiments, as shown in FIG. 3, a bottom plate of the casing 1 serves as a detachable bottom protection plate 15, to allow the second electrical portion 33 to be disassembled and assembled when the bottom protection plate 15 is removed.

The second electrical portion 33 may be mounted in or removed from the casing 1, and the bottom plate of the casing 1 is a detachable bottom protection plate 15, to allow the second electrical portion 33 to be disassembled and assembled when the bottom protection plate 15 is removed. When the second electrical portion 33 needs to be maintained, the bottom protection plate 15 is disengaged from the battery pack 100, and then the second electrical portion 33 is taken out.

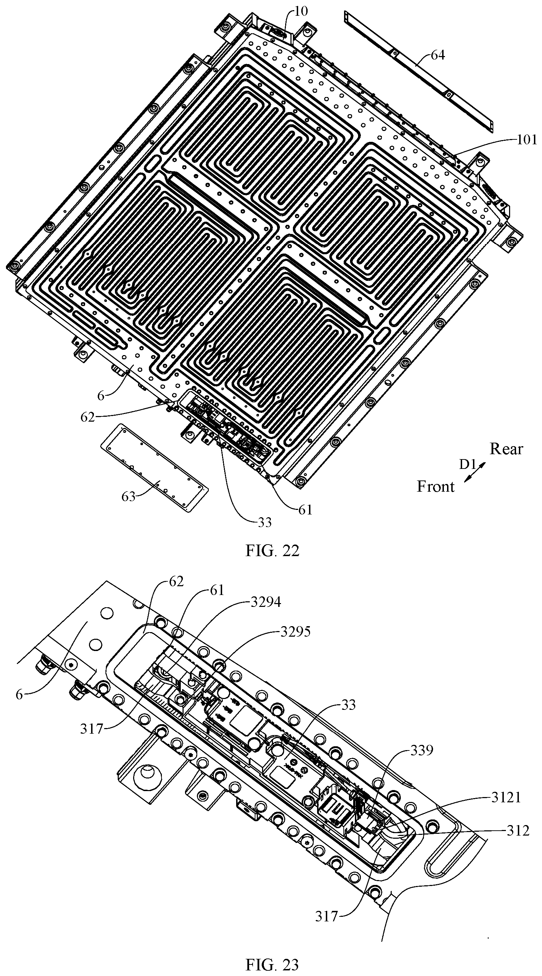

In an embodiment of the present disclosure, as shown in FIG. 22 and FIG. 23, the battery pack 100 further includes a liquid cooling plate 6 located below the battery group 2 and the electrical module 3. The bottom protection plate 15 is detachably connected below the liquid cooling plate 6. The liquid cooling plate 6 has a bottom access opening 61 corresponding to the second electrical portion 33. The bottom protection plate 15 covers the bottom access opening 61.

The liquid cooling plate 6 has the bottom access opening 61. The bottom access opening 61 is located at a bottom of the battery pack 100, and its position corresponds to the second electrical portion 33. The bottom protection plate 15 may cover the bottom access opening 61. The liquid cooling plate 6 may be used to cool the battery group 2, keeping the battery group 2 within a safe temperature range.

The formation of the bottom access opening 61 at the liquid cooling plate 6 does not affect the disassembly of the second electrical portion 33. Moreover, all four peripheral edges of the liquid cooling plate 6 may each be connected to the bottom of the frame 10, further improving overall structural strength.

When the bottom protection plate 15 is applied in the vehicle 1000, on the one hand, the bottom protection plate 15 serves as the bottom plate of the electric vehicle 1000, and is capable of bearing a weight inside the vehicle 1000. On the other hand, the bottom protection plate 15 may protect the internal structure of the battery pack 100 and reduce damage.

In an embodiment of the present disclosure, as shown in FIG. 6, the liquid cooling plate 6 has a liquid flow channel formed in the liquid cooling plate 6, the liquid flow channel is configured to circulate cooling liquid. The liquid cooling plate 6 is provided with a liquid cooling pipe 601 for an inflow or outflow of the liquid. An end of the liquid cooling pipe 601 is provided with a liquid cooling connector 602 configured to be connected to an external water tank. The liquid cooling connector 602 may be mounted at the frame 10, for example, at the front side wall 11.

Further, as shown in FIG. 22, a sealing ring 62 needs to be provided around the periphery of the bottom access opening 61, to improve sealing performance of the bottom access opening 61 during use.

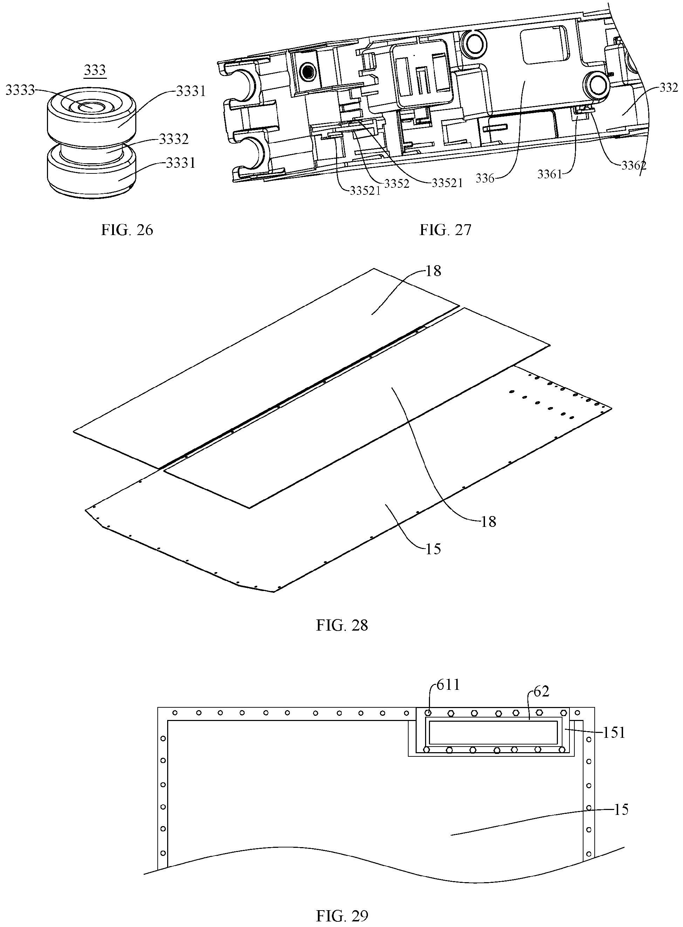

A position of the bottom access opening 61 is relatively flexible. For example, in FIG. 22, the liquid cooling plate 6 is provided with a sealing ring 62 arranged around the bottom access opening 61. For another example, in FIG. 29, the bottom protection plate 15 is provided with a sealing ring 62 arranged around the bottom access opening 61.

In other embodiments, as shown in FIG. 22, the battery pack 100 further includes a bottom access cover 63 covering the bottom access opening 61. The bottom access cover 63 is detachably connected to the liquid cooling plate 6 and located above the bottom protection plate 15. The bottom access cover 63 can protect the internal structure of the battery pack 100, preventing the dust, moisture, and the like from entering the battery pack 100 through the bottom access opening 61.

In an embodiment of the present disclosure, the bottom access cover 63 is provided with the sealing ring 62 arranged around the bottom access opening 61, further improving sealing protection for the bottom access opening 61.

Further, as shown in FIG. 29, the battery pack 100 includes a plurality of fastening bolts 611 configured to connect the bottom protection plate 15 and the liquid cooling plate 6 and distributed around the bottom access opening 61. Through the fastening bolts 611, the bottom protection plate 15 and the liquid cooling plate 6 at the bottom access opening 61 can be fastened, improving connection reliability and sealing performance at the bottom access opening 61.

In some optional embodiments, as shown in FIG. 29, an upper surface of the bottom protection plate 15 is provided with an upwardly protruding thickened layer 151. A projection surface of the thickened layer 151 on the liquid cooling plate 6 completely covers the bottom access opening 61. In this way, after the bottom protection plate 15 is connected and fixed to the upper portion of the frame 10, the thickened layer 151 is pressed upward, thereby compressing the bottom access opening 61 and improving the sealing performance.

In some optional embodiments, as shown in FIG. 28, a buffer layer 18 may be formed at the upper surface of the bottom protection plate 15 to improve buffer protection for the internal battery group 2 and electrical module 3.

In some embodiments, as shown in FIG. 13 and FIG. 6, the casing 1 is internally provided with a fixing plate 67 located above the second electrical portion 33. The second electrical portion 33 is detachably connected to the fixing plate 67 through a fourth bolt 3294. A head of the fourth bolt 3294 is located at a lower end of the structure, i.e., a mounting direction of the fourth bolt 3294 is away from the fixing plate 67 and faces the bottom access opening 61. A projection of the fourth bolt 3294 on the liquid cooling plate 6 is located within the coverage of the bottom access opening 61. Thus, the fourth bolt 3294 can be disassembled or mounted through the bottom access opening 61, improving convenience of disassembly or mounting.

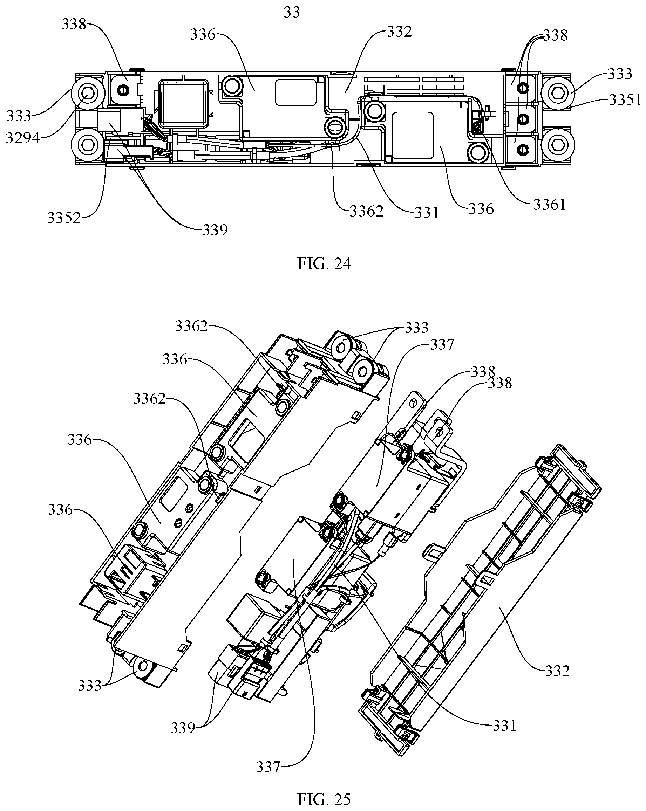

As shown in FIG. 23 and FIG. 24, in some embodiments, the second electrical portion 33 includes a second electrical housing 332 configured to receive electrical elements. In an embodiment of the present disclosure, the second electrical portion 33 further includes a first extension plate 3351 connected to at least one side of the second electrical housing 332. The first extension plate 3351 has an engagement groove extending through a side of the first extension plate 3351 away from the second electrical housing 332. The battery pack 100 further includes a shock-absorbing post 333 arranged vertically.

As shown in FIG. 26, the shock-absorbing post 333 includes two thick post segments 3331 and a thin post segment 3332 located between the two thick post segments 3331. As shown in FIG. 24 and FIG. 25, the thin post segment 3332 is engaged in the engagement groove, and the two thick post segments 3331 are clamped at upper and lower sides of the first extension plate 3351. The shock-absorbing post 333 has a central hole 3333, and the fourth bolt 3294 passes through the central hole 3333 and is connected to the fixing plate 67. By providing the shock-absorbing post 333, on the one hand, the shock-absorbing post 333 can be connected to the fixing plate 67 to improve connection reliability. On the other hand, the shock-absorbing post 333 can absorb vibration of the second electrical portion 33 to protect the electrical elements received in the second electrical housing 332.

For ease of disassembly, the electrical connection structure 31 is electrically connected to the second electrical portion 33 through a flexible wiring harness. For example, a communication connector of the second electrical portion 33 is a first signal transmission interface 339, and a second wiring harness 312 of the electrical connection structure 31 is connected to a second signal transmission interface 3121. The first signal transmission interface 339 and the second signal transmission interface 3121 are plugged and connected to each other.

As shown in FIG. 23, the first signal transmission interface 339 is located at a bottom of the second electrical housing 332. Therefore, when the bottom access opening 61 is opened, a state of the interface can be observed very conveniently. In an embodiment of the present disclosure, the second signal transmission interface 36 is plugged into the first signal transmission interface 339 from a side. In this way, while facilitating manual plugging and unplugging of the second signal transmission interface 36, a gravity of wires carried by the interface can be utilized to reduce shaking.

In an embodiment of the present disclosure, the first signal transmission interface 339 is connected to an interior of the second electrical housing 332 through a plurality of fourth flexible wires 331. Thus, the second electrical portion 33 can be connected to the electrical connection structure 32 through the first transmission interface 319.

In some specific embodiments, as shown in FIG. 25, the second electrical housing 332 of the second electrical portion 33 is detachably connected within the casing 1. The second electrical portion 33 includes a main relay 337, an electrical connection strip 338, and a first transmission interface 319. The main relay 337 is disposed within the electrical housing 1. An end of the electrical connection strip 338 is connected to the main relay 337, and another end of the electrical connection strip 338 is located outside the second electrical housing 332. The electrical connection strip 338 is configured to connect high-voltage electricity. The main relay 337 may control the high-voltage electricity.

In an embodiment of the present disclosure, the electrical connection structure 32 includes a copper busbar 317 and a second transmission interface 37. An end of the copper busbar 317 is connected to the other end of the electrical connection strip 338 through a fifth bolt 3295. The second signal transmission interface 36 is plugged into the first signal transmission interface 339, thereby establishing an electrical connection between the second electrical portion 33 and the electrical connection structure 32.

Exemplarily, the copper busbar 317 is an elongated shape and has a certain toughness to be bendable. An insulating cover is provided at a connection between the copper busbar 317 and the electrical connection strip 338, and is connected to the second electrical housing 332. When the second electrical portion 33 needs to be removed, the second electrical portion 33 shall first be de-energized. Next, the insulating cover is removed, and a fixing structure between the copper busbar 317 and the electrical connection strip 338 is disengaged. Then, the fifth bolt 3295 may be loosened. By unplugging the second transmission interface 37, the fourth bolt 3294 is exposed, and the fourth bolt 3294 may be loosened.

As shown in FIG. 27, in some embodiments, the second electrical portion 33 further includes a second extension plate 3352 connected to the second electrical housing 332. An engagement hook 33521 is provided at each of two opposite sides of the second extension plate 3352. Two first signal transmission interfaces 339 are provided and located at the two opposite sides of the second extension plate 1352. Each first signal transmission interface 339 has an engagement groove engaged with the engagement hook 33521. Thus, the first signal transmission interfaces 339 can be fixed on the second electrical housing 332, which can reduce connection costs and improve connection reliability through the snap-fit connection form.

As shown in FIG. 25, in some embodiments, two main relays 337 are provided and spaced apart from each other, and two lower protrusions 336 protruding downwardly are formed at the bottom of the second electrical housing 332, the two lower protrusions 336 cover lower parts of the two main relays 337, respectively. The bottom of the second electrical housing 332 has a second through-hole 3361 adjacent to each of the two lower protrusions 336. A part of the fourth flexible wire 331 passes through one of the second through-holes 3361 and extends into the second electrical housing 332, and another part of the fourth flexible wire 331 passes through the other second through-hole 3361 and extends into the second electrical housing 332. In this way, the second electrical housing 332 can be utilized to limit an arrangement position of the fourth flexible wire 331, thereby reducing a probability of interference with other components and an adverse effect on the signal.

In an embodiment of the present disclosure, as shown in FIG. 25 and FIG. 27, a wire clamp 3362 is provided at a side of at least one lower protrusion 336 and is configured to limit the fourth flexible wire 331. Thus, a movement of the wire clamp 3362 can be limited, reducing swing of the wire clamp 3362.

In some embodiments, the frame 10 is formed by sequentially connecting a plurality of frame side beams 103 in a length direction of the frame 10 to finally form an annular structure referred to as the frame 10. In an embodiment of the present disclosure, the front side wall 11 is composed of at least one frame side beam 103, the rear side wall 12 is composed of at least one frame side beam 103, the left side wall 13 is composed of at least one frame side beam 103, and the right side wall 14 is composed of at least one frame side beam 103.

Each frame side beam 103 includes at least two frame body portions 1031 distributed in the height direction, and a closed side beam inner cavity is formed in each frame body portion 1031. Each frame side beam 103 may include two frame body portions 1031 sequentially stacked in the height direction. In some solutions, two adjacent frame body portions 1031 are connected by a connection rib.

Each frame side beam 103 is integrally roll-formed from a steel plate or is an integrally formed extruded aluminum profile. In this way, all frame body portions 1031 of each frame side beam 103, or all the frame body portions 1031 and all connection ribs, are continuous. Moreover, each side of the frame body portion 1031 is formed by rolling or extruding, rather than being formed by stretching ordinary profiles. In this way, on the one hand, welding between the sides of the same frame body portion 1031 and between the two adjacent frame body portions can be reduced, thereby reducing processing procedures. On the other hand, the two adjacent frame body portions not only have a spliced and stacked positional relationship, but also are tied together along their connecting edges, resulting in stronger integrity and a significant improvement in overall structural strength.

Further, the mounting beam 17 is integrally roll-formed from a steel plate or is an integrally formed extruded aluminum profile.

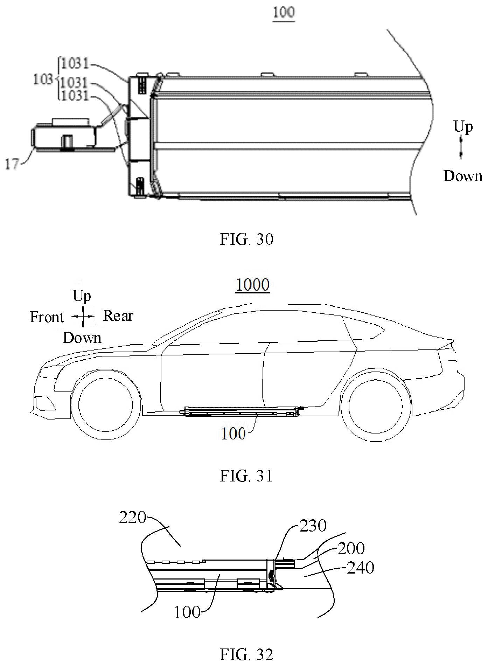

As shown in FIG. 31, the vehicle 1000 according to an embodiment of the present disclosure includes a vehicle body 200 and the battery pack 100 according to the above embodiments. A further description of the structure of the battery pack 100 is omitted here. As shown in FIG. 32, the vehicle body 200 has a passenger space 220 formed in the vehicle body 200, and the battery pack 100 is mounted at a bottom of the vehicle body 200. By adopting the above battery pack 100, it is possible to protect the internal structure of the vehicle 1000, improve the integrated design of the battery pack 100 and the vehicle 1000, reduce the number of parts, and reduce the cost and weight.

In an embodiment of the present disclosure, the vehicle body 200 has a mounting opening 230 formed at the bottom of the vehicle body 200, and the battery pack 100 is located in the mounting opening 230. The vehicle body 200 further has an upwardly recessed cavity 240 at the bottom of the vehicle body 200, and a rear end of the battery pack 100 directly faces the upwardly recessed cavity 240. In this way, during maintenance, the electronic control structure 32 in the side access opening 101 can be maintained through the upwardly recessed cavity 240 from below, eliminating the need to disassemble the entire vehicle, resulting in less damage to the vehicle.

Other arrangements and operations of the vehicle 1000 according to the embodiments of the present disclosure are known to those of ordinary skill in the art, and the description thereof in detail will be omitted herein.

In the description of this specification, descriptions with reference to "an embodiment", "an example", or the like mean that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Moreover, the particular features, structures, materials, or characteristics described may be combined in any suitable manner in one or more embodiments or examples.

Although embodiments of the present disclosure have been illustrated and described, it is conceivable for those skilled in the art that various changes, modifications, replacements, and variations can be made to these embodiments without departing from the principles and spirit of the present disclosure. The scope of the present disclosure shall be defined by the claims as appended and their equivalents.

## Claims

1. A battery pack (100), **characterized by** comprising:
a casing (1) having a side access opening (101) formed at the casing (1); and
an electronic control structure (32) disposed in the casing (1) and directly facing the side access opening (101), the electronic control structure (32) comprising a first BDU unit (321), wherein the first BDU unit (321) comprises:
a first electrical housing (3211) having a first opening (3211a) facing the side access opening (101); and
a fuse (3212) and a current sensor (3213) that are detachably disposed in the first electrical housing (3211), the current sensor (3213) being connected in series with the fuse (3212).

2. The battery pack (100) according to claim 1, wherein:
the first electrical housing (3211) has a first positioning cavity (3211e) and a second positioning cavity (3211h) that are open towards the side access opening (101), the fuse (3212) being located in the first positioning cavity (3211e), and the current sensor (3213) being located in the second positioning cavity (3211h);
first positioning protuberances (3211c) are formed on at least one side of the first positioning cavity (3211e) inside the first electrical housing (3211), an end of the fuse (3212) being detachably connected to the first positioning protuberances (3211c); and
second positioning protuberances (3211f) are formed on at least one side of the second positioning cavity (3211h) inside the first electrical housing (3211), an end of the current sensor (3213) being detachably connected to the second positioning protuberances (3211f).

3. The battery pack (100) according to claim 2, wherein a threaded hole is formed at each of a surface of the first positioning protuberances (3211c) facing the side access opening (101) and a surface of the second positioning protuberances (3211f) facing the side access opening (101), the fuse (3212) being connected to the first positioning protuberances (3211c) by bolts, and the current sensor (3213) being connected to the second positioning protuberances (3211f) by bolts.

4. The battery pack (100) according to claim 2 or 3, wherein the first positioning protuberances (3211c) and the second positioning protuberances (3211f) are staggered in height and are at different distances from the side access opening (101).

5. The battery pack (100) according to any one of claims 2 to 4, wherein the first BDU unit (321) further comprises a first conductive sheet (3214) located in the first positioning cavity (3211e) at a side of the fuse (3212) away from the side access opening (101), wherein:
a part of a side edge of the first conductive sheet (3214) extends laterally and is bent to be connected to one of the first positioning protuberances (3211c) to be electrically connected to the fuse (3212); and
a part of an upper edge of the first conductive sheet (3214) extends upward and is bent to be connected to one of the second positioning protuberances (3211f) to be electrically connected to the current sensor (3213).

6. The battery pack (100) according to any one of claims 2 to 5, wherein:
the first electrical housing (3211) has a second opening (3211b) formed at a top of the first electrical housing (3211); and
the first BDU unit (321) further comprises a top protection cover (3216) and two second conductive sheets (3215), the two second conductive sheets (3215) being spaced apart from each other in a left-right direction and disposed at the top of the first electrical housing (3211), and each of the two second conductive sheets (3215) extending in a front-rear direction.

7. The battery pack (100) according to claim 6, further comprising a battery group (2), wherein:
a rear end of one of the two second conductive sheets (3215) is bent downward to rest on one of the first positioning protuberances (3211c) to be electrically connected to the fuse (3212), and a rear end of the other one of the two second conductive sheets (3215) is bent downward to rest on one of the second positioning protuberances (3211f) to be electrically connected to the current sensor (3213), wherein a front end of each of the two second conductive sheets (3215) is connected to the battery group (2) through a copper busbar (317); and
the top protection cover (3216) is detachably connected to the top of the first electrical housing (3211) and covers over the two second conductive sheets (3215).

8. The battery pack (100) according to claim 6 or 7, wherein:
the current sensor (3213) has a first plug interface (32131) at a rear side of the current sensor (3213); and
the top protection cover (3216) has a first through-hole (3216a) directly facing the first plug interface (32131).

9. The battery pack (100) according to claim 8, wherein:
a top surface of the top protection cover (3216) has a limiting slot (3216b) extending in the front-rear direction, a front end of the limiting slot (3216b) directly facing the first through-hole (3216a); and
the top protection cover (3216) is further provided with a limiting protrusion (3216c) on at least one side of the limiting slot (3216b).

10. The battery pack (100) according to any one of claims 1 to 9, wherein the electronic control structure (32) further comprises a BMS main control board (322) and a BMS slave control board (323) that are respectively located at two sides of the first BDU unit (321) and directly face the side access opening (101).

11. A vehicle (1000), comprising the battery pack (100) according to any one of claims 1 to 10.
